(19) Europäisches Patentamt
European Patent Office
Office européen des brevets

(11) EP 3 742 513 A1

(12) # EUROPEAN PATENT APPLICATION

(43) Date of publication:
**25.11.2020 Bulletin 2020/48**

(51) Int Cl.:
***H01L 51/54*** *(2006.01)*

(21) Application number: **19175626.1**

(22) Date of filing: **21.05.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Novaled GmbH**
**01099 Dresden (DE)**

(72) Inventors:
- **Park, Moo Jin**
  **01099 Dresden (DE)**
- **Huang, Qiang**
  **01099 Dresden (DE)**

(74) Representative: **Bittner, Thomas L.**
**Boehmert & Boehmert**
**Anwaltspartnerschaft mbB**
**Pettenkoferstrasse 22**
**80336 München (DE)**

(54) **ORGANIC LIGHT EMITTING DIODE**

(57) The present invention relates to an organic light emitting diode comprising an anode, a light emitting layer, a hole transport layer and an electron blocking layer, wherein the hole transport layer and the electron blocking layer are arranged between the anode and the light emitting layer, and the electron blocking layer is adjacent to and in contact with the light emitting layer, wherein the electron blocking layer comprises a compound of the following Formula (I)

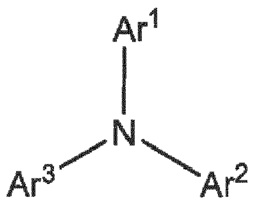

(I)

wherein $Ar^1$, $Ar^2$ and Ar3 are independently selected from the group consisting of $C_6$ to $C_{48}$ aryl and at least one of Ar1 to Ar3 is represented by the following Formula (II)

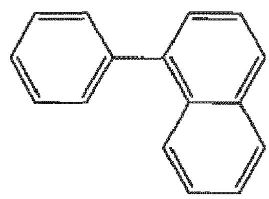

(II)

wherein the hole transport layer comprises a hole transport matrix compound, wherein the energy level of the highest occupied molecular orbital of the hole transport matrix compound is more negative than the energy level of the highest occupied molecular orbital of the following compound

EP 3 742 513 A1

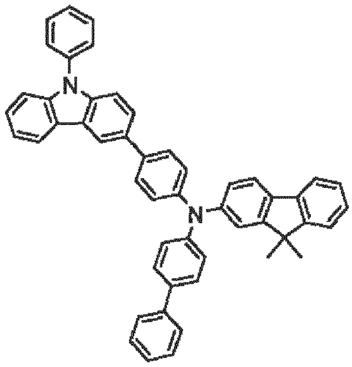

wherein the respective energy levels of the highest occupied molecular orbitals are determined on an absolute energy scale taking vacuum energy level as zero.

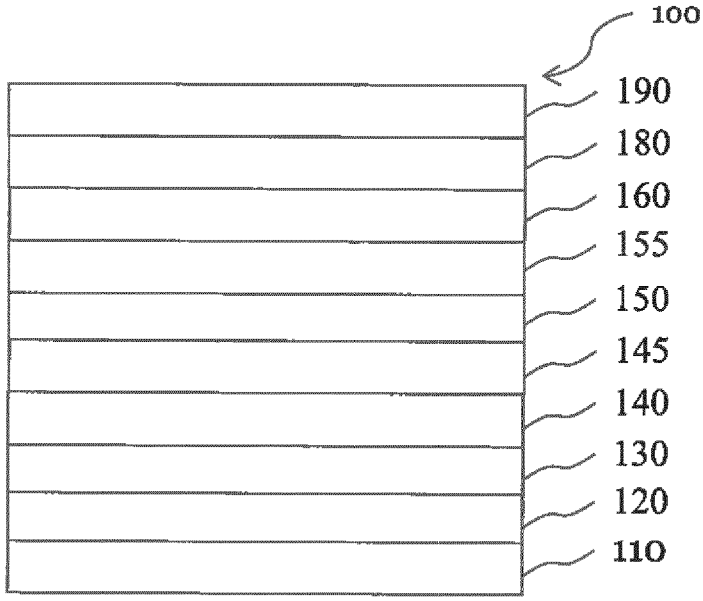


Fig.1

## Description

The present invention relates to an organic light emitting diode optimized with respect to the electronic properties of the layer structure thereof.

BACKGROUND ART

Organic light-emitting diodes (OLEDs), which are self-emitting devices, have a wide viewing angle, excellent contrast, quick response, high brightness, excellent driving voltage characteristics, and color reproduction. A typical OLED includes an anode, a hole transport layer (HTL), an emission layer (EML), an electron transport layer (ETL), and a cathode, which are sequentially stacked on a substrate. In this regard, the HTL, the EML, and the ETL are thin films formed from organic and / or organometallic compounds.

When a voltage is applied to the anode and the cathode, holes injected from the anode electrode move to the EML, via the HTL, and electrons injected from the cathode electrode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency.

Organic electroluminescent devices comprising hole injection, hole transport and electron blocking layers (frequently abbreviated HIL, HTL and EBL, respectively) belong to industrial standard in state-of-art AMOLED displays. State-of-art hole transport matrix compound for a hole injection and/or hole transport layer may be represented by compound C1

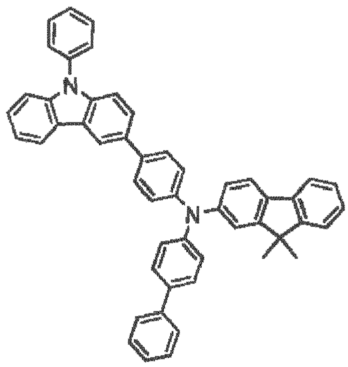

C1,

known as N-([1,1'-biphenyl]-4-yl)9,9-dimethyl-N-(4-(9-phenyl-9H-carbazol-3-yl)phenyl)-9H-fluoren-2-amine, CAS 1242056-42-3.

State of art hole injection materials and/or p-dopants may be represented by compounds HATCN, PD1 and PD2:

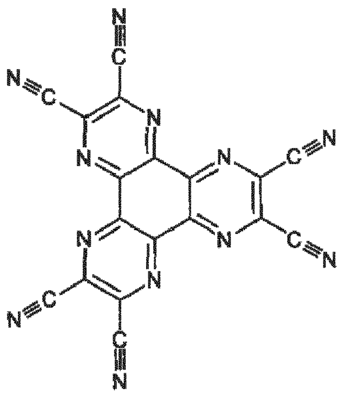

HATCN

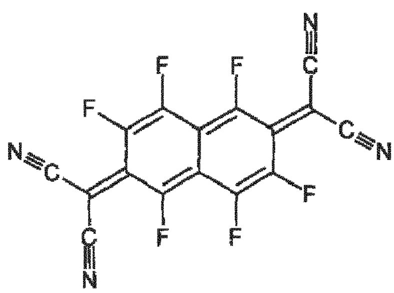

PD1

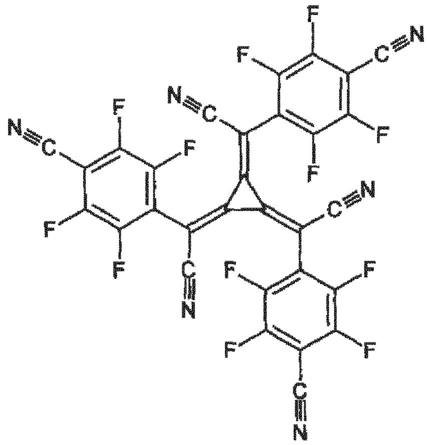

PD2

As an example of a state-of-art EBL matrix may serve compounds C2,

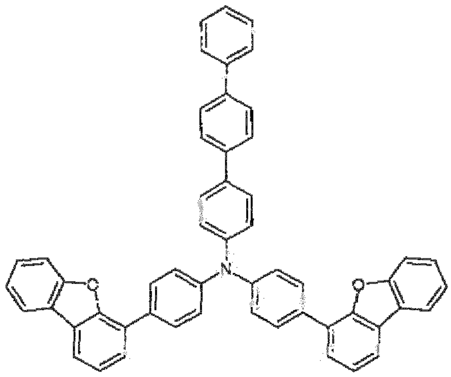

CAS 1198399-61-9 , or C3.

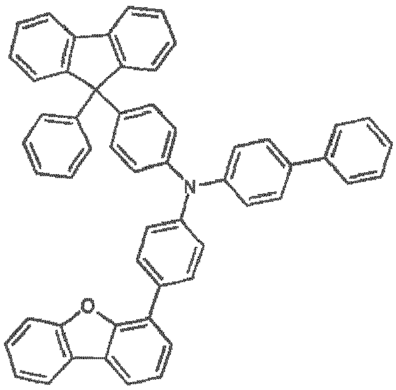

CAS 1824678-59-2 .

Nevertheless, there is still a need to improve the performance of organic light emitting devices. It is, therefore, the object of the present invention to provide an organic light emitting device overcoming drawbacks of the prior art, in particular an organic light emitting diode having improved performance.

The above object is achieved by an organic light emitting diode comprising an anode, a light emitting layer, a hole transport layer and an electron blocking layer, wherein the hole transport layer and the electron blocking layer are arranged between the anode and the light emitting layer, and the electron blocking layer is adjacent to and in contact with the light emitting layer, wherein the electron blocking layer comprises a compound of the following Formula (I)

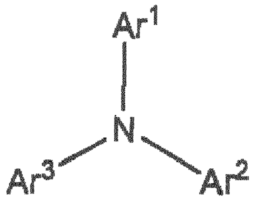

(I)

wherein $Ar^1$, $Ar^2$ and $Ar^3$ are independently selected from the group consisting of $C_6$ to $C_{48}$ aryl and at least one of $Ar^1$ to $Ar^3$ is represented by the following Formula (II)

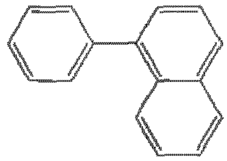

(II)

wherein the hole transport layer comprises a hole transport matrix compound, wherein the energy level of the highest occupied molecular orbital of the hole transport matrix compound is more negative than the energy level of the highest occupied molecular orbital of the above described compound C1 (CAS 1242056-42-3), wherein the respective energy levels of the highest occupied molecular orbitals are determined on an absolute energy scale taking vacuum energy level as zero.

It was surprisingly found by the inventors that the use of a compound of formula (I) in an electron blocking layer of an organic light emitting diode together with a compound having a specific HOMO energy level in a hole transport layer adjacent to the electron blocking layer is helpful to improve the performance of a respective light emitting diode. It was further surprisingly found by the inventors that the preferred embodiments referred to in the following are particularly helpful to further improve the performance. Best performance was achieved by combining two or more of the below prepared embodiments.

In the claims and the entire disclosure herein it is, to improve legibility, referred to a hole transport layer, a light emitting layer etc. using the singular. However, unless explicitly mentioned else, it may be provided that the inventive organic light emitting diodes comprises one or two or more of the respective layers. For example, the inventive organic light emitting diode may comprise one, two, three etc. hole transport layers. In this regard, it is provided that at least one of these layers comprises a compound as referred to herein. Likewise, it may be provided that more than one (or even all) of the respective layers fulfill the requirements.

The moiety having the formula (II) may, in principle, be connected to the nitrogen atom of the compound having the formula (I) by any position thereof with a single bond between the moiety of formula (II) and the nitrogen atom.

The energy level of the highest occupy molecular orbital of the hole transport matrix compound, respectively of the compound C1 (CAS 1242056-42-3) is determined by computing by a standard TURBOMOLE package using B3LYP functional and Gaussian 6-31G* base.

In one embodiment, two of $Ar^1$ to $Ar^3$ are represented by the following Formula (II)

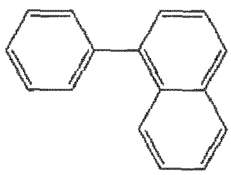

(II).

In a further embodiment, at least one of $Ar^1$ to $Ar^3$ is represented by the following Formula (III)

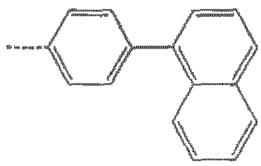

(III)

wherein the dashed line represents the binding position to the nitrogen atom of Formula (I).

In a further embodiment at least one of $Ar^1$ to $Ar^3$ comprises a structural element represented by the following Formula (IV)

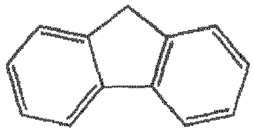

(IV)

In this regard, it may be provided that connection between the nitrogen atom of the formula (I) and the group comprising the structural element represented by formula (IV) as made by a single bond between the nitrogen atom of formula (I) and the structural element of formula (IV) or by a further structural element attached to the structural element of formula (IV), wherein the first case of a directed connection is preferred.

In one embodiment, it may be provided that at least one $Ar^1$ to $Ar^3$ is represented by the following Formula (V)

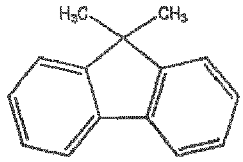

(V)

In one embodiment, the light emitting layer comprises a blue emitter.

In another embodiment the blue emitter is a blue fluorescent emitter.

The organic light emitting diode may further comprise a cathode, a hole blocking layer and an electron transport layer, wherein the hole blocking layer is arranged between the light emitting layer and the cathode, the hole blocking layer is adjacent to the light emitting layer and the electron transport layer is adjacent to the hole blocking layer.

The hole blocking layer and the electron transport layer may comprises an electron transport matrix compound comprising a structural moiety represented by the following Formula (VI)

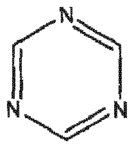

(VI)

The electron transport layer may comprise a n-dopant.

The n-dopant may be selected from the group consisting of metal salts, metal complexes and elemental metals.

At least one layer between the anode and the light emitting layer may comprise a p-dopant.

The p-dopant may be selected from the group consisting of metal salts, metal complexes and organic compound comprising at least one nitrile group.

In one embodiment, the hole transport matrix compound which has a HOMO energy level more negative than the respective energy level of the compound C1 (CAS 1242056-42-3) may have the following formula

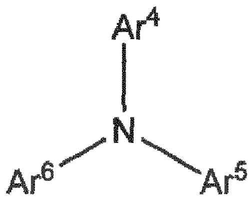

(VIII)

wherein $Ar^4$, $Ar^5$ and $Ar^6$ are independently selected from the group consisting of $C_6$ to $C_{48}$ aryl - provided that the respective compound fulfills the requirements with respect to the HOMO energy level thereof as defined herein.

Furthermore, it may be provided that at least one of $Ar^4$, $Ar^5$ and $Ar^6$ is selected from the following groups IX to XI

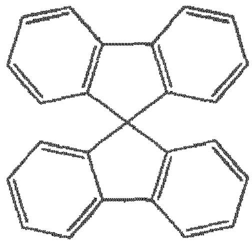

(IX)

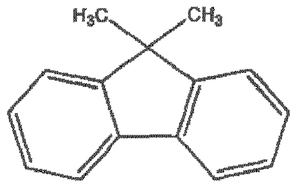

(X)

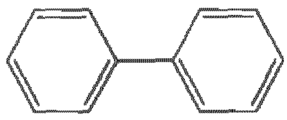

(XI)

In a further embodiment, it may be provided that $Ar^4$ is represented by formula (IX), Ar5 is represented by the formula (X) and $Ar^6$ is represented by the formula (XI).

In a further embodiment, the hole transport matrix compound comprised in the hole transport layer is represented by the following compound B1

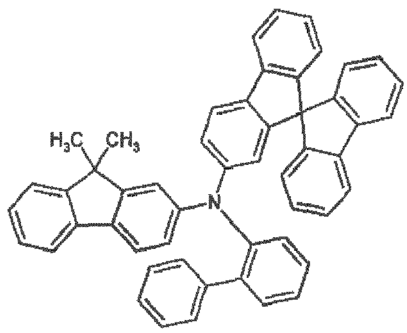

B1, CAS 1364603-07-5.

The object is further achieved by a device comprising at least one organic light emitting diode as defined herein, wherein the device is a display device or a lighting device.

Preferred embodiments with respect to the organic light emitting diodes are also preferred embodiments for the device comprising such a diode.

FURTHER LAYERS

The organic light emitting device (= organic light emitting diode) according to the invention comprises a variety of different layers stacked together to form the essential functional part of the organic light emitting device. Further details as to the respective layers and regions of the organic light emitting device according to the present invention are provided in the following.

Electron transport region

An electron transport region of the stack of organic layers forming the organic light emitting device may be disposed on the emission layer.

The electron transport region of the stack of organic layers includes at least the first electron transport layer and optional a second electron transport layer. The electron transport region of the stack of organic layers may further include an electron injection layer.

For example, the electron transport region of the stack of organic layers may have a structure of the first electron transport layer/electron injection or as an alternative a first electron transport layer/second electron transport layer/electron injection layer but is not limited thereto. For example, an organic light emitting diode according to an embodiment of the present invention includes at least one electron transport layer, and in this case, the electron transport layer comprising the electrical p-dopant and the at least one first electron transport matrix compound is defined as the first electron transport layer. In another embodiment, the organic light emitting diode may comprise at least two electron transport layers in the electron transport region of the stack of organic layers, and in this case, the electron transport layer contacting the emission layer is defined as the second electron transport layer.

The electron transport layer may include one or two or more different electron transport matrix compounds.

The thickness of the first electron transport layer may be from about 2 nm to about 100 nm, for example about 3 nm to about 30 nm. When the thickness of the first electron transport layer is within these ranges, the first electron transport layer may have improved electron transport auxiliary ability without a substantial increase in driving voltage.

A thickness of the optional second electron transport layer may be about 10 nm to about 100 nm, for example about 15 nm to about 50 nm. When the thickness of the electron transport layer is within these ranges, the electron transport layer may have satisfactory electron transporting ability without a substantial increase in driving voltage.

First electron transport matrix compound

First electron transport matrix is not particularly limited. Similarly as other materials which are in the inventive device comprised outside the emitting layer, the second electron transport matrix may not emit light.

According to one embodiment, the first electron transport matrix can be an organic compound, an organometallic compound, or a metal complex.

According to one embodiment, the first electron transport matrix may be a covalent compound comprising a conjugated system of at least 6 delocalized electrons. Under a covalent material in a broadest possible sense, it might be understood a material, wherein at least 50 % of all chemical bonds are covalent bonds, wherein coordination bonds are also considered as covalent bonds. In the present application, the term encompasses in the broadest sense all usual electron transport matrices which are predominantly selected from organic compounds but also e.g. from compounds comprising structural moieties which do not comprise carbon, for example substituted 2,4,6-tribora-1,3,5 triazines, or from metal complexes, for example aluminium tris(8-hydroxyquinolinolate).

The molecular covalent materials can comprise low molecular weight compounds which may be, preferably, stable enough to be processable by vacuum thermal evaporation (VTE). Alternatively, covalent materials can comprise polymeric covalent compounds, preferably, compounds soluble in a solvent and thus processable in form of a solution. It is to be understood that a polymeric substantially covalent material may be crosslinked to form an infinite irregular network, however, it is supposed that such crosslinked polymeric substantially covalent matrix compound still comprises both skeletal as well as peripheral atoms. Skeletal atoms of the covalent compound are covalently bound to at least two neighbour atoms. Other atoms of the covalent compound are peripheral atoms which are covalently bound with a single neighbour atom. Inorganic infinite crystals or fully crosslinked networks having partly covalent bonding but substantially lacking peripheral atoms, like silicon, germanium, gallium arsenide, indium phosphide, zinc sulfide, silicate glass etc are not considered as covalent matrices in the sense of present application, because such fully crosslinked covalent materials comprise peripheral atoms only on the surface of the phase formed by such material. A compound comprising cations and anions is still considered as covalent, if at least the cation or at least the anion comprises at least ten covalently bound atoms.

Preferred examples of covalent first electron transport matrix compounds are organic compounds, consisting predominantly from covalently bound C, H, O, N, S, which may optionally comprise also covalently bound B, P, As, Se. In one embodiment, the first electron transport matrix compound lacks metal atoms and majority of its skeletal atoms is selected from C, O, S, N.

In another embodiment, the first electron transport matrix compound comprises a conjugated system of at least six, more preferably at least ten, even more preferably at least fourteen delocalized electrons.

Examples of conjugated systems of delocalized electrons are systems of alternating pi- and sigma bonds. Optionally, one or more two-atom structural units having the pi- bond between its atoms can be replaced by an atom bearing at least one lone electron pair, typically by a divalent atom selected from O, S, Se, Te or by a trivalent atom selected from N, P, As, Sb, Bi. Preferably, the conjugated system of delocalized electrons comprises at least one aromatic or heteroaromatic ring adhering to the Hückel rule. Also preferably, the first electron transport matrix compound may comprise at least two aromatic or heteroaromatic rings which are either linked by a covalent bond or condensed.

In one of specific embodiments, the first electron transport matrix compound comprises a ring consisting of

covalently bound atoms and at least one atom in the ring is phosphorus.

In a more preferred embodiment, the phosphorus-containing ring consisting of covalently bound atoms is a phosphepine ring.

In another preferred embodiment, the first electron transport compound comprises a phosphine oxide group. Also preferably, the s first electron transport matrix compound comprises a heterocyclic ring comprising at least one nitrogen atom. Examples of nitrogen containing heterocyclic compounds which are particularly advantageous as first electron transport matrix compound for the inventive device are matrices comprising, alone or in combination, pyridine structural moieties, diazine structural moieties, triazine structural moieties, quinoline structural moieties, benzoquinoline structural moieties, quinazoline structural moieties, acridine structural moieties, benzacridine structural moieties, dibenzacridine structural moieties, diazole structural moieties and benzodiazole structural moieties.

The first electron transport matrix compound may have a molecular weight (Mw) of ≥ 400 to ≤ 850 g / mol, preferably ≥ 450 to ≤ 830 g / mol. If the molecular weight is selected in this range, particularly reproducible evaporation and deposition can be achieved in vacuum at temperatures where good long-term stability is observed.

Preferably, the first electron transport matrix compound may be essentially non-emissive.

In another embodiment, the first electron transport matrix compound may have dipole moment, computed using the hybrid functional B3LYP with a Gaussian 6-31G* basis set as implemented in the program package TURBOMOLE V6.5 for the lowest energy conformer found by the program package TURBOMOLE V6.5 using the hybrid functional B3LYP with a Gaussian 6-31G* basis set, higher than 2.3 Debye. It may be a preferred embodiment in combination with redox dopants selected from elemental metals.

According to a further aspect of the invention, the reduction potential of the first electron transport matrix compound, if measured under the same conditions by cyclic voltammetry against Fc/Fc+ in tetrahydrofuran, may have a value which is less negative than the value obtained for triphenylphosphine oxide and more negative than the value obtained for tetrakis(quinoxalin-5-yloxy)zirconium.

Under these conditions the redox potential of triphenylphosphine oxide is about -3.06 V and the reduction potential of tetrakis(quinoxalin-5-yloxy)zirconium is about -1.78 V.

According to a further aspect of the invention, the redox potential of the first electron transport matrix compound, if measured under the same conditions by cyclic voltammetry against Fc/Fc+ in tetrahydrofuran, may have a value which is less negative than the respective value obtained for triphenylphosphine oxide, preferably less negative than the respective value for bis(4-(9H-carbazol-9-yl)phenyl)-(phenyl)phosphine oxide, more preferably less negative than the respective value for 3-([1,1'-biphenyl]-4-yl)-5-(4-(tert-butyl)phenyl)-4-phenyl-4H-1,2,4-triazole, even more preferably less negative than the respective value for pyrene, most preferably less negative than the respective value for 2,7-di-pyrenyl-9,9-spirobifluorene, also preferably less negative than the respective value for 4,7-diphenyl-1,10-phenanthroline, also preferably less negative than the respective value for 2,4,7,9-tetraphenyl-1,10-phenanthroline, also preferably less negative than the respective value for 7-([1,1'-biphenyl]-4-yl)dibenzo[c,h]acridine, also preferably less negative than the respective value for 2,4,6-triphenyltriazine, and still preferably less negative than the respective value for 2,4,6-tri(biphenyl-4-yl)-1,3,5-triazine.

According to a further aspect of the invention, the redox potential of the first electron transport matrix compound, if measured under the same conditions by cyclic voltammetry against Fc/Fc+ in tetrahydrofuran, may have the value which is more negative than the respective value obtained for tetrakis(quinoxalin-5-yloxy)zirconium, preferably more negative than the respective value for 4,4'-bis(4,6-diphenyl-1,3,5-triazin-2-yl)-1,1'-biphenyl, most preferably more negative than the respective value for 2,4,6-tri(biphenyl-4-yl)-1,3,5-triazine.

The redox potential can be determined by following standard method, using cyclic voltammetry with potentiostatic device Metrohm PGSTAT30 and software Metrohm Autolab GPES at room temperature. The redox potentials given at particular compounds are measured in an argon de-aerated, dry 0.1M THF solution of the tested substance, under argon atmosphere, with 0.1M tetrabutylammonium hexafluorophosphate supporting electrolyte, between platinum working electrodes and with an Ag/AgCl pseudo-standard electrode (Metrohm Silver rod electrode), consisting of a silver wire covered by silver chloride and immersed directly in the measured solution, with the scan rate 100 mV/s. The first run is done in the broadest range of the potential set on the working electrodes, and the range was then adjusted within subsequent runs appropriately. The final three runs are done with the addition of ferrocene (in 0.1M concentration) as the standard. The average of potentials corresponding to cathodic and anodic peak of the studied compound, after subtraction of the average of cathodic and anodic potentials observed for the standard Fc+/Fc redox couple, afford finally the values reported above. All studied compounds as well as the reported comparative compounds showed well-defined reversible electrochemical behaviour.

Examples of electron transport layers and suitable electron transport matrix compounds can be found e.g. in recently published application WO 2018/138373 A1.

According to various embodiments of the electroluminescent device, wherein the first electron transport layer comprises about ≤ 100 wt.-% to about ≥ 30 wt.-%, preferably ≤ 95 wt.-% to about ≥ 40 wt.-%, of a matrix compound, based on the total weight of the first electron transport layer.

Preferably, the first electron transport matrix compound may be essentially non-emissive.

Second electron transport matrix

Second electron transport compound is not particularly limited. Similarly as other materials which are in the inventive device comprised outside the emitting layer, the second electron transport matrix may not emit light.

According to one embodiment, the second electron transport matrix compound can be an organic compound, an organometallic compound, or a metal complex.

Compounds listed as examples of the first electron transport matrix compound can be used also as the second electron transport matrix compound.

According to one embodiment, the device comprises in addition a second electron transport layer comprising at least one second electron transport matrix compound which is selected from covalent compounds comprising a conjugated system of at least 6 delocalized electrons, preferably from organic compounds comprising at least one aromatic ring, more preferably from organic compounds comprising at least two aromatic rings, even more preferably from organic compounds comprising at least three aromatic rings, most preferably from organic compounds comprising at least four aromatic rings; and the second electron transport layer is arranged between the first electron transport layer and the light emitting layer, preferably the second hole transport layer is formed of the second electron transport matrix compound, and further preferably the second electron transport layer is adjacent arranged to the first electron transport layer and/or to the light emitting layer.

According to one embodiment, the second electron transport matrix compound may be a covalent compound comprising a conjugated system of at least 6 delocalized electrons.

In one embodiment, the dipole moment of the second electron transport matrix compound is selected $\geq$ 0.5 Debye and $\leq$ 4.5 Debye, preferably $\geq$ 1.0 Debye and < 4.0 Debye, more preferably $\geq$ 1.5 Debye and < 3.5 Debye.

According to a further aspect of the invention, the redox potential of the second electron matrix compound may be selected less negative than -2.35 V and more negative than -2.14 V, preferably less negative than -2.3 V and more negative than -2.16 V, more preferably less negative than -2.25 V and more negative than -2.16 V, when measured against Fc/Fc+ in tetrahydrofuran.

Redox n-dopant

Under redox n-dopant, it is understood a compound which, if embedded into an electron transport matrix, increases concentration of free electrons in comparison with the neat matrix under the same physical condictions measured by cyclic voltammetry against ferrocene/ferrocenium reference redox couple.

The redox n-dopant may not emit light under the operation condition of an electroluminescent device, for example an OLED. In one embodiment, the redox n-dopant is selected from an elemental metal, an electrically neutral metal complex and/or an electrically neutral organic radical.

The most practical benchmark for the strength of an n-dopant is the value of its redox potential. There is no particular limitation in terms how negative the value of the redox potential can be.

As redox potentials of usual electron transport matrices used in organic light emitting diodes are, if measured by cyclic voltammetry against ferrocene/ferrocenium reference redox couple, roughly in the range from about - 1.8 V to about - 3.1V; the practically applicable range of redox potentials for n-dopants which can effectively n-dope such matrices is in a slightly broader range, from about - 1.7 V to about - 3.3 V.

The measurement of redox potentials is practically performed for a corresponding redox couple consisting of the reduced and of the oxidized form of the same compound.

In case that the redox n-dopant is an electrically neutral metal complex and/or an electrically neutral organic radical, the measurement of its redox potential is actually performed for the redox couple formed by

(i) the electrically neutral metal complex and its cation radical formed by an abstraction of one electron from the electrically neutral metal complex, or

(ii) the electrically neutral organic radical and its cation formed by an abstraction of one electron from the electrically neutral organic radical.

Preferably, the redox potential of the electrically neutral metal complex and/or of the electrically neutral organic radical may have a value which is more negative than - 1.7 V, preferably more negative than - 1.9 V, more preferably more negative than - 2.1 V, even more preferably more negative than - 2.3 V, most preferably more negative than - 2.5 V, if measured by cyclic voltammetry against ferrocene/ferrocenium reference redox couple for a corresponding redox couple consisting of

(i) the electrically neutral metal complex and its cation radical formed by an abstraction of one electron from the electrically neutral metal complex, or

(ii) the electrically neutral organic radical and its cation formed by an abstraction of one electron from the electrically neutral organic radical.

In a preferred embodiment, the redox potential of the n-dopant is between the value which is about 0.5 V more positive and the value which is about 0.5 V more negative than the value of the reduction potential of the chosen electron transport matrix.

Electrically neutral metal complexes suitable as redox n-dopants may be e.g. strongly reductive compelxes of some transition metals in low oxidation state. Particularly strong redox n-dopants may be selected for example from Cr(II), Mo(II) and/or W(II) guanidinate complexes such as W2(hpp)4, as described in more detail in WO2005/086251.

Electrically neutral organic radicals suitable as redox n-dopants may be e.g. organic radicals created by supply of additional energy from their stable dimers, oligomers or polymers, as described in more detail in EP 1 837 926 B1, WO2007/107306, or WO2007/107356. Specific examples of such suitable radicals may be diazolyl radicals, oxazolyl radicals and/or thiazolyl radicals.

Under an elemental metal, it is understood a metal in a state of a neat metal, of a metal alloy, or in a state of free atoms or metal clusters. It is understood that metals deposited by vacuum thermal evaporation from a metallic phase, e.g. from a neat bulk metal, vaporize in their elemental form. It is further understood that if the vaporized elemental metal is deposited together with a covalent matrix, the metal atoms and/or clusters are embedded in the covalent matrix. In other words, it is understood that any metal doped covalent material prepared by vacuum thermal evaporation contains the metal at least partially in its elemental form.

For the use in consumer electronics, only metals containing stable nuclides or nuclides having very long halftime of radioactive decay might be applicable. As an acceptable level of nuclear stability, the nuclear stability of natural potassium can be taken.

In one embodiment, the n-dopant is selected from electropositive metals selected from alkali metals, alkaline earth metals, rare earth metals and metals of the first transition period Ti, V, Cr and Mn. Preferably, the n-dopant is selected from Li, Na, K, Rb, Cs, Mg, Ca, Sr, Ba, Sm, Eu, Tm, Yb; more preferably from Li, Na, K, Rb, Cs, Mg and Yb, even more preferably from Li, Na, Cs and Yb, most preferably from Li, Na and Yb.

The redox dopant may be essentially non-emissive.

## Hole injection layer

The inventive organic light emitting device may comprise one or more hole injection layers. Unless mentioned else (in particular with respect to the second hole injection layer) the hole injection layer may have the below properties and may comprise the below materials for forming the same.

The hole injection layer may improve interface properties between the anode and an organic material used for the hole transport layer, and is applied on a non-planarized anode and thus planarizes the surface of the anode. For example, the hole injection layer may include a material having a median value of the energy level of its highest occupied molecular orbital (HOMO) between the work function of the anode material and the energy level of the HOMO of the hole transport layer, in order to adjust a difference between the work function of the anode and the energy level of the HOMO of the hole transport layer.

When the hole transport region includes a hole injection layer, the hole injection layer may be formed on the anode by any of a variety of methods, for example, vacuum deposition, spin coating, casting, Langmuir-Blodgett (LB) method, or the like.

When hole injection layer is formed using vacuum deposition, vacuum deposition conditions may vary depending on the material that is used to form the hole injection layer, and the desired structure and thermal properties of the hole injection layer to be formed and for example, vacuum deposition may be performed at a temperature of about 100 °C to about 500 °C, a pressure of about 10-6 Pa to about 10-1 Pa, and a deposition rate of about 0.1 to about 10 nm/sec, but the deposition conditions are not limited thereto.

When the hole injection layer is formed using spin coating, the coating conditions may vary depending on the material that is used to form the hole injection layer, and the desired structure and thermal properties of the hole injection layer to be formed. For example, the coating rate may be in the range of about 2000 rpm to about 5000 rpm, and a temperature at which heat treatment is performed to remove a solvent after coating may be in a range of about 80 °C to about 200 °C, but the coating conditions are not limited thereto.

Examples of hole transport matrix materials suitable for the present invention may be found e.g. in WO 2013/135237 A1, WO 2014/060526 A1 or WO 2015/158886 A1 and in documents cited therein, or in recently published applications WO2018/150006 A1, WO 2018/150048 A1, WO 2018/150049 A1, WO 2018/150050 A1 and WO

2018/150051 A1.

Hole transport layer

Conditions for forming the hole transport layer and the electron blocking layer may be defined based on the above-described formation conditions for the hole injection layer.

A thickness of the hole transport part of the charge transport region may be from about 10 nm to about 1000 nm, for example, about 10 nm to about 100 nm. When the hole transport transport part of the charge transport region includes the hole injection layer and the hole transport layer, a thickness of the hole injection layer may be from about 10 nm to about 1000 nm, for example about 10 nm to about 100 nm and a thickness of the hole transport layer may be from about 5 nm to about 200 nm, for example about 10 nm to about 150 nm. When the thicknesses of the hole transport part of the charge transport region, the HIL, and the HTL are within these ranges, satisfactory hole transport characteristics may be obtained without a substantial increase in driving voltage.

In accordance with the present invention, the organic light emitting diode comprises at least one hole transport layer comprising a hole transport matrix compound wherein the energy level of the highest occupied molecular orbital of the hole transport matrix compound is more negative than the energy level of the highest occupied molecular orbital of the compound CAS 1242056-42-3 wherein the respective energy level of the highest occupied molecular orbitals are determined on an absolute energy scale taking vacuum energy level as zero. The organic light emitting diode may comprise more than one hole transport layer. In such a case, at least one of the above layers contains the hole transport matrix compound as defined herein. Likewise, it may be provided that two or more of these layers comprise a respective compound. Alternatively, in case that not all of the hole transport layers comprise the hole transport matrix compound as defined herein, other hole transport matrix materials may be used in the respective layers not comprising the hole transport matrix compound. Likewise, it may be provided that in other layer, the hole transport matrix compound as defined herein is mixed with other hole transport matrix materials.

Such other hole transport matrix materials used in the hole transport region are not particularly limited. Preferred are covalent compounds comprising a conjugated system of at least 6 delocalized electrons, preferably organic compounds comprising at least one aromatic ring, more preferably organic compounds comprising at least two aromatic rings, even more preferably organic compounds comprising at least three aromatic rings, most preferably organic compounds comprising at least four aromatic rings. Typical examples of hole transport matrix materials which are widely used in hole transport layers are polycyclic aromatic hydrocarbons, triaryl amine compounds and heterocyclic aromatic compounds. Suitable ranges of frontier orbital energy levels of hole transport matrices useful in various layer of the hole transport region are well-known. In terms of the redox potential of the redox couple HTL matrix/ cation radical of the HTL matrix, the preferred values (if measured by cyclic voltammetry against ferrocene/ferrocenium redox couple as reference) may be in the range 0.0 - 1.0 V, more preferably in the range 0.2 - 0.7 V, even more preferably in the range 0.3 - 0.5 V.

Examples of hole transport matrix materials suitable for the present invention may be found e.g. in WO 2013/135237 A1, WO 2014/060526 A1 or WO 2015/158886 A1 and in documents cited therein, or in recently published applications WO 2018/150006 A1, WO 2018/150048 A1, WO 2018/150049 A1, WO 2018/150050 A1 and WO 2018/150051 A1.

The hole transport region of the stack of organic layers shall further include an electrical p-dopant improving conductivity and/or hole injection from the anode, in addition to the materials as described above.

Electrical p-dopant

The charge-generating material may be homogeneously or inhomogeneously dispersed in the first hole transport layer.

The electrical p-dopant may be one of a quinone derivative, a radialene compound, a metal oxide, and a cyano group-containing compound, but is not limited thereto. Nonlimiting examples of the p-dopant are quinone derivatives such as tetracyanoquinonedimethane (TCNQ), 2,3,5,6-tetrafluoro-tetracyano-1,4-benzoquinonedimethane ($F_4$-TCNQ), radialene compounds like PD-2 and the like; metal oxides such as tungsten oxide, molybdenum oxide, and the like; and cyano-containing compounds such as compound HATCN above.

Buffer layer

The hole transport part of the charge transport region may further include a buffer layer.

Buffer layer that can be suitable used are disclosed in US 6 140 763, US 6 614 176 and in US206/248022.

The buffer layer may compensate for an optical resonance distance of light according to a wavelength of the light emitted from the EML, and thus may increase efficiency.

Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime are improved.

The inventive organic light emitting diode comprises one or more electron blocking layers. At least one of the one or more electron blocking layers comprises a compound having the formula (I). The electron blocking layer comprising the compounds according to formula (I) is adjacent to a hole transport layer comprising the hole transport matrix compound as defined herein fulfilling specific requirements regarding the energy level of the highest occupied molecular orbital thereof. In case that the organic light emitting diode in accordance with the present invention comprises more than one electron blocking layer all of these electron blocking layers may contain the compound of formula (I), or not all of the electron blocking layers comprise the compound of formula (I) provided that at least one of the layers comprises the compound of formula (I).

In case that the organic light emitting diode according to the invention comprises more than one electron blocking layer and not all of the electron blocking layers comprise the compound of formula (I) conventional materials known in the art may be used in the respective further electron blocking layers.

Typically, a conventional electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from compounds with a triplet level above the triplet level of the phosphorescent emitter in the adjacent emission layer. Suitable compounds for the triplet control layer, in particular the triarylamine compounds, are described in EP 2 722 908 A1.

Emission layer

The emission layer (EML) may be formed on the hole transport region by using vacuum deposition, spin coating, casting, LB method, or the like. When the emission layer is formed using vacuum deposition or spin coating, the conditions for deposition and coating may be similar to those for the formation of the hole injection layer, though the conditions for the deposition and coating may vary depending on the material that is used to form the emission layer. The emission layer may include an emitter host (EML host) and an emitter dopant (further only emitter).

The emitter may be a red, green, or blue emitter.

In one embodiment, the emitter host material is a polar emitter host compound. Preferably the the emitter host material can be a polar emitter host compound, which has a gas phase dipole moment, computed using the hybrid functional B3LYP with a Gaussian 6-31G* basis set as implemented in the program package TURBOMOLE V6.5 for the lowest energy conformer found by the program package TURBOMOLE V6.5 using the hybrid functional B3LYP with a Gaussian 6-31G* basis set, in the range from about $\geq$ 0.2 Debye to about $\leq$ 2.0 Debye.

In one embodiment, the emitter host material is a polar emitter host compound having at least three aromatic rings, which are independently selected from carbocyclic rings and heterocyclic rings.

In one preferred embodiment, the emitter host material can be a polar emitter host compound having at least three aromatic rings, which are independently selected from carbocyclic rings and heterocyclic rings, which has a has a gas phase dipole moment, computed using the hybrid functional B3LYP with a Gaussian 6-31G* basis set as implemented in the program package TURBOMOLE V6.5 for the lowest energy conformer found by the program package TURBOMOLE V6.5 using the hybrid functional B3LYP with a Gaussian 6-31G* basis set, in the range from about > 0.2 Debye to about $\leq$ 2.0 Debye.

In one embodiment, the emitter host material is a polar emitter host compound represented by the chemical Formula 1:

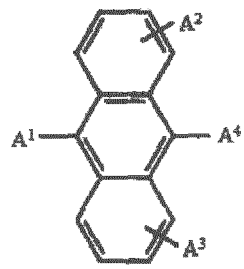

(1);

wherein

A1 is selected from the group comprising a substituted or unsubstituted C6-C60 aryl or C6-C60 heteroaryl;

A2 is selected from the group comprising a substituted or unsubstituted C1 to C10 alkyl group, a substituted or unsubstituted C6-C60 aryl or C6-C60 heteroaryl;

A3 is selected from the group comprising a substituted or unsubstituted C1 to C10 alkyl group, a substituted or unsubstituted C6-C60 aryl or C6-C60 heteroaryl;
A4 is selected from the group comprising a substituted or unsubstituted C6-C60 aryl or C6-C60 heteroaryl, preferably a C6-C60 heteroaryl.

Emitter host

The polar emitter host compound has at least three aromatic rings, which are independently selected from carbocyclic rings and heterocyclic rings.

The polar emitter host compound may have a gas phase dipole moment, computed using the hybrid functional B3LYP with a Gaussian 6-31G* basis set as implemented in the program package TURBOMOLE V6.5 for the lowest energy conformer found by the program package TURBOMOLE V6.5 using the hybrid functional B3LYP with a Gaussian 6-31G* basis set, in the range from about ≥ 0.2 Debye to about ≤ 2.0 Debye.

According to one embodiment of electroluminescent device the polar emitter host compound has at least three aromatic rings, which are independently selected from carbocyclic rings and heterocyclic rings, and may have a gas phase dipole moment, computed using the hybrid functional B3LYP with a Gaussian 6-31G* basis set as implemented in the program package TURBOMOLE V6.5 for the lowest energy conformer found by the program package TURBOMOLE V6.5 using the hybrid functional B3LYP with a Gaussian 6-31G* basis set, in the range from about ≥ 0.2 Debye to about ≤ 2.0 Debye.

In another embodiment, the emitter host compound may have a gas phase dipole moment, computed using the hybrid functional B3LYP with a Gaussian 6-31G* basis set as implemented in the program package TURBOMOLE V6.5 for the lowest energy conformer found by the program package TURBOMOLE V6.5 using the hybrid functional B3LYP with a Gaussian 6-31G* basis set, in the range from about ≥ 0.3 Debye to about ≤ 1.8 Debye, preferably in the range from about ≥ 0.5 Debye to about ≤ 1.6 Debye, even more preferred in the range from about ≥ 0.6 Debye to about ≤ 1.4 Debye, and most preferred in the range from about ≥ 0.7 Debye to about ≤ 1.3 Debye.

The dipole moment $|\vec{\mu}|$ of a molecule containing N atoms is given by:

$$\vec{\mu} = \sum_{i}^{N} q_i \vec{r_i}$$

$$|\vec{\mu}| = \sqrt{\mu_x^2 + \mu_y^2 + \mu_z^2}$$

where $q_i$ and d $\vec{r_i}$ are the partial charge and position of atom i in the molecule.

The partial charges and atomic positions are computed for the lowest energy conformation of the ground state a molecule in a gas phase, by a standardized method, using the hybrid functional B3LYP with a Gaussian 6-31G* basis set as implemented in the program package TURBOMOLE V6.5. If more than one conformation is viable, the energy of the possible conformations is computed using the hybrid functional B3LYP with a Gaussian 6-31G* basis set as implemented in the program package TURBOMOLE V6.5 first, and the conformation with the lowest total energy is selected to determine the dipole moment.

The dipole moments and redox potentials of compounds which may be suitable as the second electron transport matrix compound can be found in recently published application WO 2018/138373 A1. According to a further aspect of the invention, the emitter host respectively has a redox potential which, if measured under the same conditions by cyclic voltammetry against Fc/Fc+ in tetrahydrofuran, has a value more negative than the respective value obtained for 7-([1,1'-biphenyl]-4-yl)dibenzo[c,h]acridine, preferably more negative than the respective value for 9,9',10,10'-tetraphenyl-2,2'-bianthracene, more preferably more negative than the respective value for 2,9-di([1,1'-biphenyl]-4-yl)-4,7-diphenyl-1,10-phenanthroline, even more preferably more negative than the respective value for 2,4,7,9-tetraphenyl-1,10-phenanthroline, even more preferably more negative than the respective value for 9,10-di(naphthalen-2-yl)-2-phenylanthracene, even more preferably more negative than the respective value for 2,9-bis(2-methoxyphenyl)-4,7-diphenyl-1,10-phenanthroline, most preferably more negative than the respective value for 9,9'-spirobi[fluorene]-2,7-diylbis(diphenylphosphine oxide).

The emitter is mixed in a small amount to cause light emission. The emitter may be, for example an inorganic, organic, or organometallic compound, and one or more kinds thereof may be used.

The emitter may be a fluorescent emitter; for example ter-fluorene, 4.4'-bis(4-diphenyl aminostyryl)biphenyl (DPAVBi), 2,5,8,11-tetra-tert-butyl perylene (TBPe), and Compound 4 below are examples of fluorescent blue emitters.

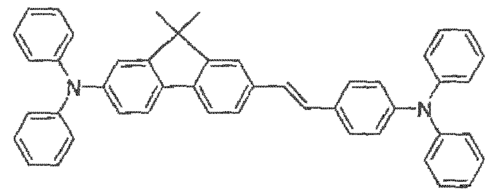

Compound 4

A thickness of the emission layer may be about 10 nm to about 100 nm, for example about 20 nm to about 60 nm. When the thickness of the emission layer is within these ranges, the emission layer may have improved emission characteristics without a substantial increase in a driving voltage.

Electron injection layer

According to another aspect of the invention, the organic electroluminescent device may further comprise an electron injection layer between the first electron transport layer and the cathode.

The electron injection layer (EIL) may facilitate injection of electrons from the cathode.

According to another aspect of the invention, the electron injection layer comprises:

(i) an electropositive metal selected from alkali metals, alkaline earth metals and rare earth metals in substantially elemental form, preferably selected from Li, Na, K, Rb, Cs, Mg, Ca, Sr, Ba, Eu and Yb, more preferably from Li, Na, Mg, Ca, Sr and Yb, even more preferably from Li and Yb, most preferably Yb; and/or

(ii) an alkali metal complex and/or alkali metal salt, preferably the Li complex and/or salt, more preferably a Li quinolinolate, even more preferably a lithium 8-hydroxyquinolinolate, most preferably the alkali metal salt and/or complex of the second electron transport layer is identical with the alkali metal salt and/or complex of the injection layer.

The electron injection layer may include at least one selected from LiF, NaCl, CsF, Li2O, and BaO.

A thickness of the EIL may be from about 0.1 nm to about 10 nm, or about 0.3 nm to about 9 nm. When the thickness of the electron injection layer is within these ranges, the electron injection layer may have satisfactory electron injection ability without a substantial increase in driving voltage.

Cathode

A material for the cathode may be a metal, an alloy, or an electrically conductive compound that have a low work function, or a combination thereof. Specific examples of the material for the cathode may be lithium (Li), magnesium (Mg), aluminum (Al), aluminum-lithium (Al-Li), calcium (Ca), magnesium-indium (Mg-In), magnesium-silver (Mg-Ag), etc. In order to manufacture a top-emission light-emitting device having a reflective anode deposited on a substrate, the cathode may be formed as a transmissive electrode from, for example, indium tin oxide (ITO) or indium zinc oxide (IZO).
In devices comprising a transparent metal oxide cathode or a reflective metal cathode, the cathode may have a thickness from about 50 nm to about 100 nm, whereas semitransparent metal cathodes may be as thin as from about 5 nm to about 15 nm.

Anode

A material for the anode may be a metal or a metal oxide, or an organic material, preferably a material with work function above about 4.8 eV, more preferably above about 5.1 eV, most preferably above about 5.3 eV. Preferred metals are noble metals like Pt, Au or Ag, preferred metal oxides are transparent metal oxides like ITO or IZO which may be advantageously used in bottom-emitting OLEDs having a reflective cathode.
In devices comprising a transparent metal oxide anode or a reflective metal anode, the anode may have a thickness from about 50 nm to about 100 nm, whereas semitransparent metal anodes may be as thin as from about 5 nm to about 15 nm.

Organic light emitting diode (OLED)

According to one aspect of the present invention, there is provided an organic light-emitting diode (OLED) comprising: a substrate; an anode electrode formed on the substrate; a hole injection layer, the hole transport layer, the electron blocking layer an emission layer, and a cathode electrode.
According to another aspect of the present invention, there is provided an OLED comprising: a substrate; an anode electrode formed on the substrate; a hole injection layer, the hole transport layer, the electron blocking layer, an emission layer, a hole blocking layer, and a cathode electrode.
According to another aspect of the present invention, there is provided an OLED comprising: a substrate; an anode electrode formed on the substrate; a hole injection layer, the hole transport layer, the electron blocking layer, an emission layer, a hole blocking layer, an electron injection layer, and a cathode electrode.
According to various embodiments of the present invention, there may be provided OLEDs layers arranged between the above mentioned layers, on the substrate or on the top electrode.
According to one aspect, the OLED can comprise a layer structure of a substrate that is adjacently arranged to an anode electrode, the anode electrode is adjacently arranged to a first hole injection layer, the first hole injection layer is adjacently arranged to a first hole transport layer, the first hole transport layer is adjacently arranged to a first electron blocking layer, the first electron blocking layer is adjacently arranged to a first emission layer, the first emission layer is adjacently arranged to a first electron transport layer, the first electron transport layer is adjacently arranged to an n-type charge generation layer, the n-type charge generation layer is adjacently arranged to a hole generating layer, the hole generating layer is adjacently arranged to a second hole transport layer, the second hole transport layer is adjacently arranged to a second electron blocking layer, the second electron blocking layer is adjacently arranged to a second emission layer, between the second emission layer and the cathode electrode an optional electron transport layer and/or an optional injection layer are arranged.
For example, the OLED (100) according to Fig. 1 may be formed by a process, wherein
on a substrate (110), an anode (120), a hole injection layer (130), the hole transport layer (140), the electron blocking layer (145), an emission layer (150), a hole blocking layer (155), an electron transport layer (160), an electron injection layer (180) and the cathode electrode (190) are subsequently formed in that order.
According to another aspect of the present invention, there is provided a method of manufacturing an organic light emitting diode, the method using:

- at least one deposition source, preferably two deposition sources and more preferred at least three deposition sources.

The methods for deposition that can be suitable comprise:

- deposition via vacuum thermal evaporation;

- deposition via solution processing, preferably the processing is selected from spin-coating, printing, casting; and/or
- slot-die coating.

According to various embodiments of the present invention, there is provided a method using:

- a first deposition source to release the compound (I) according to the invention, and
- a second deposition source to release a metal, a metal complex, an organo-metallic compound, a metal salt or an alkali or alkaline earth metal complex; alternatively an organic alkali or alkaline earth metal complex; alternatively 8-hydroxyquinolinolato lithium or alkali borate;

the method comprising the steps of forming the organic semiconducting layer; whereby for an organic light-emitting diode (OLED):

- the organic semiconducting layer is formed by releasing the compound (I) according to the invention from the first deposition source and a metal, a metal complex, an organo-metallic compound, a metal salt or an alkali or alkaline earth metal complex; alternatively an organic alkali or alkaline earth metal complex; alternatively 8-hydroxyquinolinolato lithium or alkali borate, from the second deposition source.

According to various embodiments of the present invention, the method may further include forming on the anode electrode, an emission layer the hole transport layer, and the electrode blocking layer.

According to various embodiments of the present invention, the method may further include the steps for forming an organic light-emitting diode (OLED), wherein

- on a substrate a first anode electrode is formed,
- on the first anode electrode an emission layer is formed,
- on the emission layer an electron transport layer stack is formed, optionally a hole blocking layer is formed on the emission layer and an organic semiconducting layer is formed,
- and finally a cathode electrode is formed,
- a hole transport layer, and an electron blocking layer, formed in that order between the first anode electrode and the emission layer,
- optionally an electron injection layer is formed between the organic semiconducting layer and the cathode electrode.

According to various embodiments, the OLED may have the following layer structure, with the layers having the following order:

anode, hole injection layer, hole transport layer, electron blocking layer, emission layer, optional hole blocking layer, optional electron injection layer, and cathode, or

anode, hole injection layer, hole transport layer, electron blocking layer, optional hole blocking layer, first electron transport layer, optional electron injection layer, and cathode, or

anode, hole injection layer, hole transport layer, electron blocking layer, emission layer, first electron transport layer, optional electron injection layer, and cathode.

According to another aspect of the invention, it is provided an electronic device comprising at least one organic light emitting device according to any embodiment described throughout this application, preferably, the electronic device comprises the organic light emitting diode in one of embodiments described throughout this application. More preferably, the electronic device is a display device.

In one embodiment, the organic light emitting diode according to the invention may further comprise a layer comprising a radialene compound and/or a quinodimethane compound.

In one embodiment, the radialene compound and/or the quinodimethane compound may be substituted with

one or more halogen atoms and/or with one or more electron withdrawing groups. Electron withdrawing groups can be selected from nitrile groups, halogenated alkyl groups, alternatively from perhalogenated alkyl groups, alternatively from perfluorinated alkyl groups. Other examples of electron withdrawing groups may be acyl, sulfonyl groups or phosphoryl groups.

Alternatively, acyl groups, sulfonyl groups and/or phosphoryl groups may comprise halogenated and/or perhalogenated hydrocarbyl. In one embodiment, the perhalogenated hydrocarbyl may be a perfluorinated hydrocarbyl. Examples of a perfluorinated hydrocarbyl can be perfluormethyl, perfluorethyl, perfluorpropyl, perfluorisopropyl, perfluorobutyl, perfluorophenyl, perfluorotolyl; examples of sulfonyl groups comprising a halogenated hydrocarbyl may be trifluoromethylsulfonyl, pentafluoroethylsulfonyl, pentafluorophenylsulfonyl, heptafluoropropylsufonyl, nonafluorobutylsulfonyl, and like.

In one embodiment, the radialene and/or the quinodimethane compound may be comprised in a hole injection, hole transporting and/or a hole generation layer.

In one embodiment, the radialene compound may have Formula (XX) and/or the quinodimethane compound may have Formula (XXIa) or (XXIb):

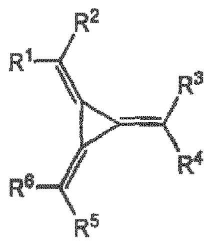

(XX)

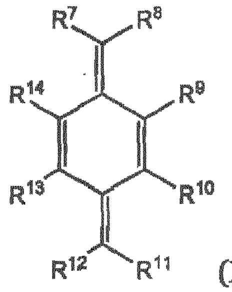

(XXIa)

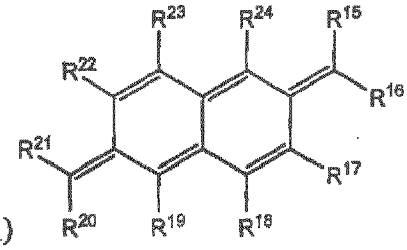

(XXIb),

wherein $R^1$, $R^2$, $R^3$, $R^4$, $R^5$, $R^6$, $R^7$, $R^8$, $R^{11}$, $R^{12}$, $R^{15}$, $R^{16}$, $R^{20}$, $R^{21}$ are independently selected from above mentioned electron withdrawing groups and $R^9$, $R^{10}$, $R^{13}$, $R^{14}$, $R^{17}$, $R^{18}$, $R^{19}$, $R^{21}$, $R^{23}$ and $R^{24}$ are independently selected from H, halogen and above mentioned electron withdrawing groups.

Hereinafter, the embodiments are illustrated in more detail with reference to examples. However, the present disclosure is not limited to the following examples. Reference will now be made in detail to the exemplary aspects.

## Details and definitions of the invention

In the present specification, when a definition is not otherwise provided, an "alkyl group" may refer to an aliphatic hydrocarbon group. The alkyl group may refer to "a saturated alkyl group" without any double bond or triple bond. The term "alkyl" as used herein shall encompass linear as well as branched and cyclic alkyl. For example, $C_3$-alkyl may be selected from n-propyl and iso-propyl. Likewise, $C_4$-alkyl encompasses n-butyl, sec-butyl and t-butyl. Likewise, $C_6$-alkyl encompasses n-hexyl and cyclo-hexyl.

The subscribed number n in $C_n$ relates to the total number of carbon atoms in the respective alkyl, arylene, heteroarylene or aryl group.

The term "aryl" or "arylene" as used herein shall encompass phenyl ($C_6$-aryl), fused aromatics, such as naphthalene, anthracene, phenanthracene, tetracene etc. Further encompassed are biphenyl and oligo- or polyphenyls, such as terphenyl etc.. Further encompassed shall be any further aromatic hydrocarbon substituents, such as fluorenyl etc. "Arylene" respectively "heteroarylene", referes to groups to which two further moieties are attached. In the present specification the term "aryl group" or "arylene group" may refer to a group comprising at least one hydrocarbon aromatic moiety, and all the elements of the hydrocarbon aromatic moiety may have p-orbitals which form conjugation, for example a phenyl group, a naphtyl group, an anthracenyl group, a phenanthrenyl group, a pyrenyl group, a fluorenyl group and the like. The aryl or arylene group may include a monocyclic or fused ring polycyclic (i.e., rings sharing adjacent pairs of carbon atoms) functional group.

The term "heteroaryl" as used herein refers to aryl groups in which at least one carbon atom is substituted with a heteroatom, preferably selected from N, O, S, B or Si.

The subscripted number n in $C_n$-heteroaryl merely refers to the number of carbon atoms excluding the number of heteroatoms. In this context, it is clear that a $C_3$ heteroarylene group is an aromatic compound comprising three carbon atoms, such as pyrazol, imidazole, oxazole, thiazole and the like.

The term "heteroaryl" may refer to aromatic heterocycles with at least one heteroatom, and all the elements of the hydrocarbon heteroaromatic moiety may have p-orbitals which form conjugation. The heteroatom may be selected from N, O, S, B, Si, P, Se, preferably from N, O and S. A heteroarylene ring may comprise at least 1 to 3 heteroatoms.

Preferably a heteroarylene ring may comprise at least 1 to 3 heteroatoms individually selected from N, S and/or O.

The term "heteroaryl" as used herewith shall encompass pyridine, quinoline, quinazoline, pyridine, triazine, benzimidazole, benzothiazole, benzo[4,5]thieno[3,2-d]pyrimidine, carbazole, xanthene, phenoxazine, benzoacridine, dibenzoacridine and the like.

In the present specification, the single bond refers to a direct bond.

The term "fluorinated" as used herein refers to a hydrocarbon group in which at least one of the hydrogen atoms comprised in the hydrocarbon group is substituted by a fluorine atom. Fluorinated groups in which all of the hydrogen atoms thereof are substituted by fluorine atoms are referred to as perfluorinated groups and are particularly addressed by the term "fluorinated".

In terms of the invention, a group is "substituted with" another group if one of the hydrogen atoms comprised in this group is replaced by another group, wherein the other group is the substituent.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

According to another aspect, the organic light emitting diode according to the present invention may comprise more than one emission layer, preferably two or three emission layers. An OLED comprising more than one emission layer is also described as a tandem OLED or stacked OLED.

The organic electroluminescent device (OLED) may be a bottom- or top-emission device.

Another aspect is directed to a device comprising at least one organic electroluminescent device (OLED).

A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural Formula.

The terms "OLED" and "organic light-emitting diode" are simultaneously used and have the same meaning. The term "organic electroluminescent device" as used herein may comprise both organic light emitting diodes as well as organic light emitting transistors (OLETs).

As used herein, "weight percent", "wt.-%", "percent by weight", "% by weight", parts by weight and variations thereof refer to a composition, component, substance or agent as the weight of that component, substance or agent of the respective electron transport layer divided by the total weight of the respective electron transport layer thereof and multiplied by 100. It is under-stood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of', "does not contain", "does not comprise" does not exclude impurities. Impurities have no technical effect with respect to the object achieved by the present invention.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about $\geq$ 380 nm to about $\leq$ 780 nm.

Preferably, the organic semiconducting layer comprising the compound (I) is essentially non-emissive or non-emitting.

The operating voltage, also named U, is measured in Volt (V) at 10 milliAmpere per square centimeter (mA/cm2).

The candela per Ampere efficiency, also named cd/A efficiency is measured in candela per ampere at 10 milliAmpere per square centimeter (mA/cm2).

The external quantum efficiency, also named EQE, is measured in percent (%).

The color space is described by coordinates CIE-x and CIE-y (International Commission on Illumination 1931). For blue emission the CIE-y is of particular importance. A smaller CIE-y denotes a deeper blue color.

The highest occupied molecular orbital, also named HOMO, and lowest unoccupied molecular orbital, also named LUMO, are measured in electron volt (eV).

The term "OLED", "organic light emitting diode", "organic light emitting device", "organic optoelectronic device" and "organic light-emitting diode" are simultaneously used and have the same meaning.

The term "life-span" and "lifetime" (LT) are simultaneously used and have the same meaning.

The anode electrode and cathode electrode may be described as anode electrode / cathode electrode or anode electrode / cathode electrode or anode electrode layer / cathode electrode layer.

Room temperature, also named ambient temperature, is 23° C.

BRIEF DESCRIPTION OF THE DRAWINGS

These and/or other aspects and advantages of the present invention will become apparent and more readily appreciated from the following description of the exemplary embodiments, taken in conjunction with the accompanying drawings, of which:

FIG. 1 is a schematic sectional view of an OLED, according to an exemplary embodiment of the present invention.

FIG. 2 is a schematic sectional view of a tandem OLED comprising a charge generation layer, according to an exemplary embodiment of the present invention.

DETAILED DESCRIPTION

Reference will now be made in detail to the exemplary embodiments of the present invention, examples of which are illustrated in the accompanying drawings, wherein like reference numerals refer to the like elements throughout The exemplary embodiments are described below, in order to explain the aspects of the present invention, by referring to the figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

Fig. 1 is a schematic sectional view of an OLED 100, according to an exemplary embodiment of the present invention. The OLED 100 of Fig. 1 comprises an electron blocking layer (EBL) 145 and a hole blocking layer (HBL) 155.

Referring to Fig. 1, the OLED 100 includes a substrate 110, an anode 120, a hole injection layer (HIL) 130, a hole transport layer (HTL) 140, an electron blocking layer (EBL) 145, an emission layer (EML) 150, a hole blocking layer (HBL) 155, an electron transport layer (ETL) 160, an electron injection layer (EIL) 180 and a cathode electrode 190.

Fig. 2 is a schematic sectional view of a tandem OLED 200, according to another exemplary embodiment of the present invention. Fig. 2 differs from Fig. 1 in that the OLED 200 of Fig. 2 further comprises a charge generation layer (CGL) and a second emission layer (151).

Referring to Fig. 2, the OLED 200 includes a substrate 110, an anode 120, a first hole injection layer (HIL) 130, a first hole transport layer (HTL) 140, a first electron blocking layer (EBL) 145, a first emission layer (EML) 150, a first hole blocking layer (HBL) 155, a first electron transport layer (ETL) 160, an n-type charge generation layer (n-type CGL) 185, a hole generating layer (p-type charge generation layer; p-type GCL) 135, a second hole transport layer (HTL) 141, a second electron blocking layer (EBL) 146, a second emission layer (EML) 151, a second hole blocking layer (EBL) 156, a second electron transport layer (ETL) 161, a second electron injection layer (EIL) 181 and a cathode 190.

While not shown in Fig. 1 and Fig. 2, a sealing layer may further be formed on the cathode electrodes 190, in order to seal the OLEDs 100 and 200. In addition, various other modifications may be applied thereto.

Experimental part

Hereinafter, one or more exemplary embodiments of the present invention will be described in detail with, reference to the following examples. However, these examples are not intended to limit the purpose and scope of the one or more exemplary embodiments of the present invention.

Supporting materials for device experiments

F1 is

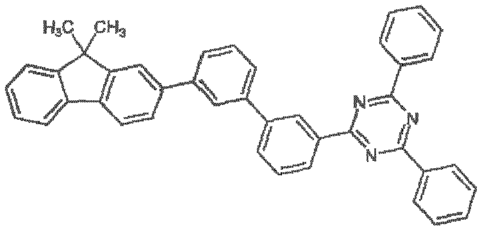

CAS 1955543-57-3

F2 is

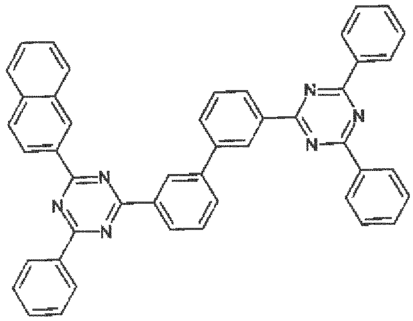

F3 is

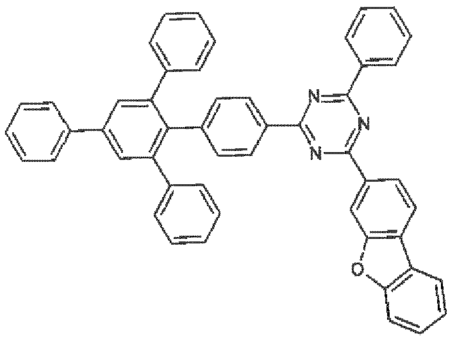

F4 is

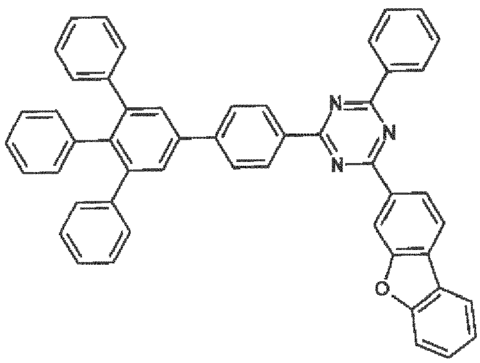

F5 is

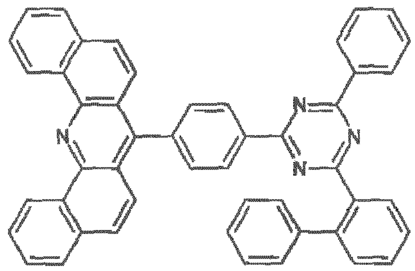

H09 is an emitter host and BD200 is a blue fluorescent emitter dopant, both commercially available from SFC, Korea.

F2 is accessible e.g. by methods disclosed for analogous compounds in WO2016/204375; F5 is accessible by methods described for analogous compounds in e.g. in EP 3 312 899.

Preparation of the compound E1

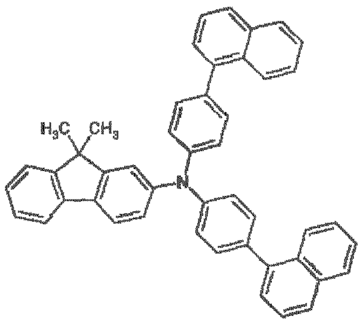

CAS 1835250-94-6 is described in KR 10-2015-0059142.

Compounds F3 and F4 were prepared as follows

<u>Preparation of 2-(dibenzo[b,d]furan-3-yl)-4-(2',6'-diphenyl-[1,1':4,1''-terphenyl]-4-yl)-6-phenyl-1,3,5-triazine (F-3)</u>

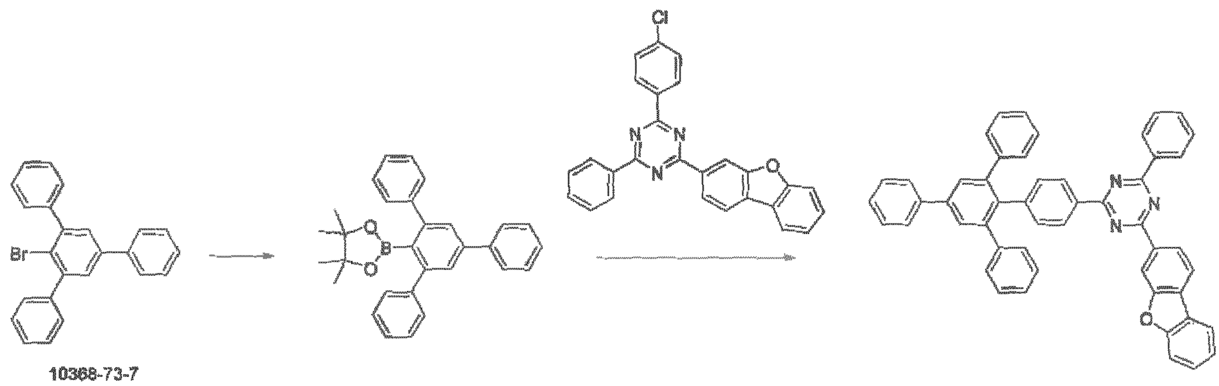


4,4,5,5-tetramethyl-2-(5'-phenyl-[1,1':3',1''-terphenyl]-2'-yl)-1,3,2-dioxaborolane

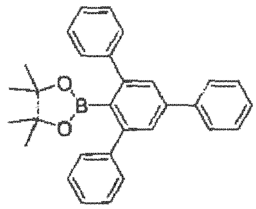

To a stirred solution of 2'-bromo-5'-phenyl-1,1':3',1''-terphenyl (60.0 g, 155.7 mmol) in THF (950 mL) at -80 °C was added n-butyllithium in n-hexane (129.6 mL, 33 wt%, 323.9 mmol) and the mixture was slowly warmed up to -60 °C during 4 hours. The green solution was then cooled down to -80 °C and 2-isopropoxy-4,4,5,5-tetramethyl-1,3,2-dioxaborolane (86.9 g, 467.2 mmol) was added slowly. The mixture was stirred overnight while the temperature gradually increased to room temperature. Methanol was added and the crude reaction mixture was evaporated to dryness. The residue was dissolved in chloroform and extracted with water three times. The organic phase was dried over $MgSO_4$, filtered and evaporated to dryness. After trituration with n-hexane and drying, 42.2 g (62%) of a white solid were obtained.

2-(dibenzo[b,d]furan-3-yl)-4-(2',6'-diphenyl-[1,1':4',1''-terphenyl]-4-yl)-6-phenyl-1,3,5-triazine (F3)

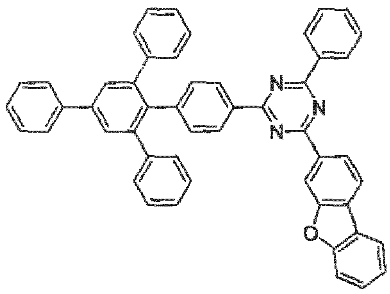

A flask was flushed with nitrogen and charged with 2-(4-chlorophenyl)-4-(dibenzo[b,d]furan-3-yl)-6-phenyl-1,3,5-triazine (10.0 g, 23 mmol), 4,4,5,5-tetramethyl-2-(5'-phenyt-[1,1':3',1''-terphenyl]-2'-yl)-1,3,2-dioxaborolane (12.0 g, 27.7 mmol), chloro(crotyl)(2-dicyclohexylphosphino-2',6'-dimethoxybiphenyl)-palladium(II) (0.28 g, 0.46 mmol), and $K_3PO_4$ (9.8 g, 46.1 mmol). A mixture of deaerated THF/water (4:1, 290 mL) was added and the reaction mixture was heated to 50 °C under a nitrogen atmosphere for two days. Additional chloro(crotyl)(2-dicydohexylphosphino-2',6'-dimethoxybiphenyl)-palladium(II) (0.28 g, 0.46 mmol) was added and the reaction mixture was heated to 70 °C under a nitrogen atmosphere for five days. After cooling down to room temperature, the formed precipitate was collected by suction filtration and washed with water and methanol. The crude product was dissolved in hot chlorobenzene and filtered through a pad of silica gel. After rinsing with additional hot chlorobenzene, the combined filtrates were concentrated in vacuo and the obtained precipitate was isolated by suction filtration and washed with n-hexane. After recrystallization from THF and drying, 4.1 g (27%) of a pale yellow solid were obtained. Final purification was achieved by sublimation. m/z = 704 ($[M+H]^+$).

Preparation of 2-(dibenzo[b,d]furan-3-yl)-4-(3',5'-diphenyl-[1,1':4',1''-terphenyl]-4-yl)-6-phenyl-1,3,5-triazine (F4)

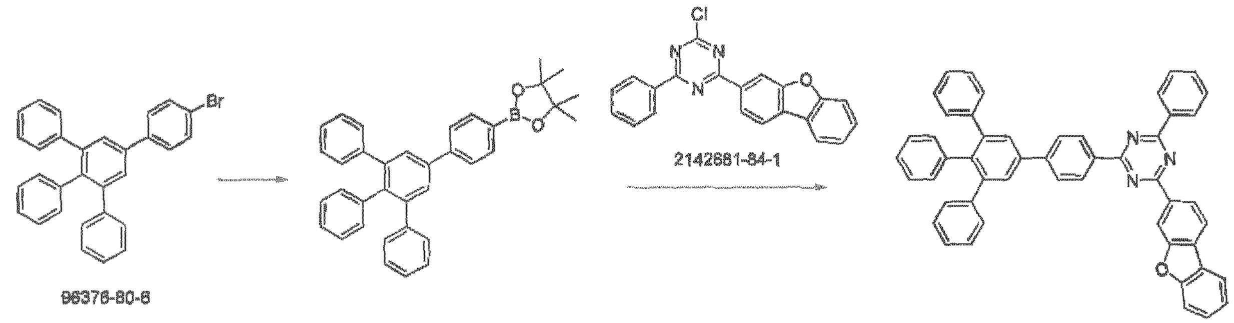


2-(3',5'diphenyl-[1,1':4',1"-terphenyl]-4-yl)-4,4,5,5-tetraniethyl-1,3,2-dioxaborolane

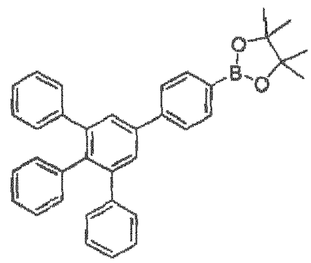

A flask was flushed with nitrogen and charged with 5'-(4-bromophenyl)-3'-phenyl-1,1':2',1"-terphenyl (11.0 g, 23.8 mmol), bis(pinacolato)diboron (6.7 g, 26.2 mmol), Pd(dppf)$Cl_2$ (1.0 g, 1.4 mmol), and potassium acetate (5.8 g, 59.6 mmol). Dry and deaerated DMF (110 mL) was added and the reaction mixture was heated to 80 °C under a nitrogen atmosphere for 22 hours. Subsequently, all volatiles were removed in vacuo, water and dichloromethane were added and the organic phase was washed with water four times. After drying over $MgSO_4$, the organic phase was filtered through a pad of Florisil. After rinsing with additional dichloromethane, the filtrate was concentrated to a minimal amount and precipitation was induced by addition of n-hexane. The precipitate was collected by suction filtration, washed with n-hexane and dried to yield 10.4 g (86%) of an off-white solid.

2-(dibenzo[b,d]furan-3-yl)-4-(3',5'-diphenyl-[1,1':4',1"-terphenyl]-4-yl)-6-phenyl-1,3,5-triazine (F4)

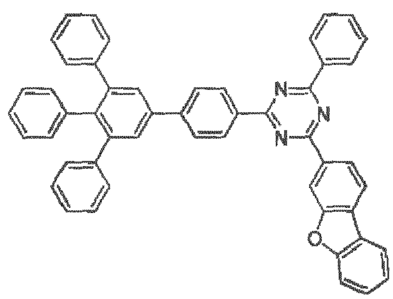

A flask was flushed with nitrogen and charged with 2-(3',5'-diphenyl-[1,1':4',1"-terphenyl]-4-yl)-4,4,5,5-tetramethyl-1,3,2-dioxaborolane (5.0 g, 9.8 mmol), 2-chloro-4-(dibenzo[b,d]furan-3-yl)-6-phenyl-1,3,5-triazine (7.1 g, 20.0 mmol), $Pd(PPh_3)_4$ (0.48 g, 0.42 mmol), and $K_2CO_3$ (5.8 g, 41.9 mmol). A mixture of deaerated 1,4-dioxane/water (5:1, 120 mL) was added and the reaction mixture was heated to reflux under a nitrogen atmosphere overnight. After cooling down to room temperature, the formed precipitate was collected by suction filtration and washed with water, methanol and n-hexane. The crude product was dissolved in hot toluene and filtered through a pad of silica gel. After rinsing with additional hot toluene, the combined filtrates were concentrated in vacuo and, after the addition of n-hexane, the obtained precipitate was isolated by suction filtration and washed with n-hexane. After trituration with toluene and drying, 4.0 g

(29%) of a white solid were obtained. Final purification was achieved by sublimation, m/z = 704 ($[M+H]^+$).

Standard procedures

Voltage stability

OLEDs are driven by constant current circuits. Those circuits can supply a constant current over a given voltage range. The wider the voltage range, the wider the power losses of such devices. Hence, the change of driving voltage upon driving needs to be minimized.

The driving voltage of an OLED is temperature dependent. Therefore, voltage stability needs to be judged in thermal equilibrium. Thermal equilibrium is reached after one hour of driving.

Voltage stability is measured by taking the difference of the driving voltage after 50 hours and after 1 hour driving at a constant current density. Here, a current density of 30 mA/cm$^2$ is used. Measurements are done at room temperature.

$$dU\,[V] = U(50\,h, 30\,mA/cm^2) - U(1\,h, 30\,mA/cm^2)$$

Examples

1) Blue fluorescent OLED

Table 1a schematically describes the model device.

Table 1a

| Layer | Material | c [vol%] | d [nm] |
|---|---|---|---|
| anode | Ag | 100 | 90 |
| HIL | C1: PD-2 or B1: PD-2 | 92:8 | 10 |
| HTL | C1 or B1 | 100 | 118 |
| EBL | C3 or E1 | 100 | 5 |
| EML | H09: BD200 | 97:3 | 20 |
| HBL | F1 | 100 | 5 |
| ETL | F2 or F3 or F4 or F5: LiQ | 50:50 | 31 |
| EIL | Yb | 100 | 2 |
| cathode | Ag:Mg | 90:10 | 13 |
| capping layer | C1 | 100 | 70 |

The results are given in Table 1b

Table 1b

| ETL | HIL+HT L/EBL' | CC-y* | U/V | CEFF/CCy | LT97/h at 30mA/cm$^2$ | ΔU/V (100-1h) at 30mA/cm$^2$ |
|---|---|---|---|---|---|---|
| F2 | C1/C3 | 0,043 | 3,71 | 165,6 | 43 | 0,019 |
| F3 | | 0,044 | 3,81 | 160,2 | 50 | 0,035 |
| F4 | | 0,043 | 3,77 | 168,1 | 42 | 0,033 |
| F5 | | 0,044 | 3,80 | 156,2 | 54 | 0,013 |
| F2 | **B1**/C3 | 0,043 | 3,47 | 153,3 | 73 | 0,028 |
| F3 | | 0,044 | 3,56 | 149,5 | 90 | 0,054 |
| F4 | | 0,044 | 3,53 | 155,3 | 80 | 0,055 |
| F5 | | 0,043 | 3,55 | 146,6 | 94 | 0,028 |

(continued)

| ETL | HIL+HT L/EBL' | CC-y* | U/V | CEFF/CCy | LT97/h at 30mA/cm2 | ΔU/V (100-1h) at 30mA/cm2 |
|---|---|---|---|---|---|---|
| F2 | C1/**E1** | 0,044 | 3,63 | 169,3 | 64 | 0,019 |
| F3 | | 0,045 | 3,72 | 165,5 | 73 | 0,038 |
| F4 | | 0,044 | 3,69 | 171,5 | 62 | 0,040 |
| F5 | | 0,045 | 3,73 | 160,9 | 82 | 0,016 |
| F2 | **B1/E1** | 0,043 | 3,41 | 154,0 | 83 | 0,026 |
| F3 | | 0,043 | 3,50 | 150,0 | 99 | 0,045 |
| F4 | | 0,043 | 3,47 | 156,9 | 90 | 0,046 |
| F5 | | 0,043 | 3,51 | 144,8 | 110 | 0,021 |

Abbreviations: cc-y is coordinate y in the CIE 1931 coulour space, U/V is the operational voltage of the model device in volts at the current density 10 $mA/cm^2$, CEFF/CCy is the current efficiency corrected as a ratio to colour coordinate y, LT97 is the operational stability in terms of time (in hours) which is necessary for 3 % luminance change in device operated at a constant current density 30 $mA/cm^2$, AU/V (100-1h) is the voltage stability (in volts) as described in standard procedures.

In comparison with state-of-art combinations C1/C3, B1/C3 and/or C1/E1, the inventive combination B1/E1 enables the sought performance improvement.

The features disclosed in the foregoing description and in the dependent claims may, both separately and in any combination thereof, be material for realizing the aspects of the disclosure made in the independent claims, in diverse forms thereof.

## Claims

1. Organic light emitting diode comprising an anode, a light emitting layer, a hole transport layer and an electron blocking layer,
wherein the hole transport layer and the electron blocking layer are arranged between the anode and the light emitting layer, and the electron blocking layer is adjacent to and in contact with the light emitting layer, wherein the electron blocking layer comprises a compound of the following Formula (I)

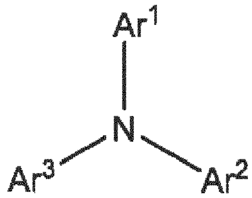

(I)

wherein $Ar^1$, $Ar^2$ and $Ar^3$ are independently selected from the group consisting of $C_6$ to $C_{48}$ aryl and at least one of $Ar^1$ to $Ar^3$ is represented by the following Formula (II)

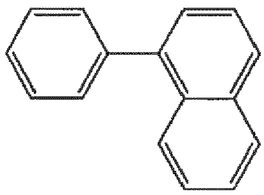

(II)

wherein the hole transport layer comprises a hole transport matrix compound, wherein the energy level of the highest occupied molecular orbital of the hole transport matrix compound is more negative than the energy level of the highest occupied molecular orbital of the following compound

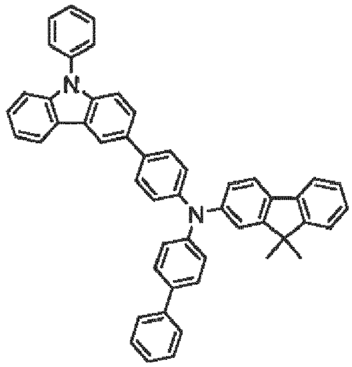

wherein the respective energy levels of the highest occupied molecular orbitals are determined on an absolute energy scale taking vacuum energy level as zero.

**2.** Organic light emitting diode according to claim 1, wherein two of $Ar^1$ to $Ar^3$ are represented by the following Formula (II)

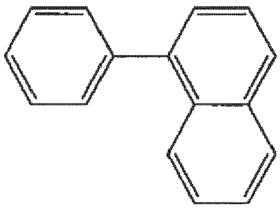

(II).

**3.** Organic light emitting diode according to claim 1 or 2, wherein at least one of $Ar^1$ to $Ar^3$ is represented by the following Formula (III)

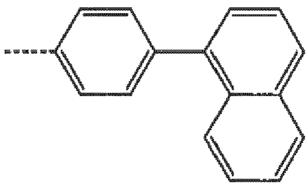

(III)

wherein the dashed line represents the binding position to the nitrogen atom of Formula (I).

**4.** Organic light emitting diode according to any of the preceding claims, wherein at least one of $Ar^1$ to $Ar^3$ comprises structural element represented by the following Formula (IV)

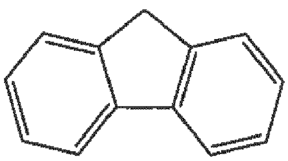

(IV)

**5.** Organic light emitting diode according to any of the preceding claims, wherein at least one of $Ar^1$ to $Ar^3$ is represented by the following Formula (V)

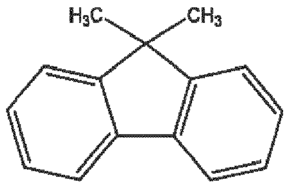

(V)

6. Organic light emitting diode according to any of the preceding claims, wherein the light emitting layer comprises a blue emitter.

7. Organic light emitting diode according to claim 6, wherein the blue emitter is a blue fluorescent emitter.

8. Organic light emitting diode according to any of the preceding claims further comprising a cathode, a hole blocking layer and an electron transport layer, wherein the hole blocking layer is arranged between the light emitting layer and the cathode, the hole blocking layer is adjacent to the light emitting layer and the electron transport layer is adjacent to the hole blocking layer.

9. Organic light emitting diode according to claim 8, wherein at least one of the hole blocking layer and the electron transport layer comprises an electron transport matrix compound comprising a structural moiety represented by the following Formula (VI)

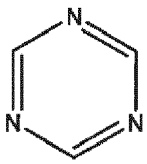

(VI)

10. Organic light emitting diode according to claim 8 or 9, wherein the electron transport layer comprises a n-dopant.

11. Organic light emitting layer according to claim 10, wherein the n-dopant is selected from the group consisting of metal salts, metal complexes and elemental metals.

12. Organic light emitting diode according to any of the preceding claims, wherein at least one layer between the anode and the light emitting layer comprises a p-dopant.

13. Organic light emitting diode according to claim 12, wherein the p-dopant is selected from the group consisting of metal salts, metal complexes and organic compound comprising at least one nitrile group.

14. Organic light emitting diode according to any of the preceding claims, wherein the hole transport matrix compound comprised in the hole transport layer is compound B1

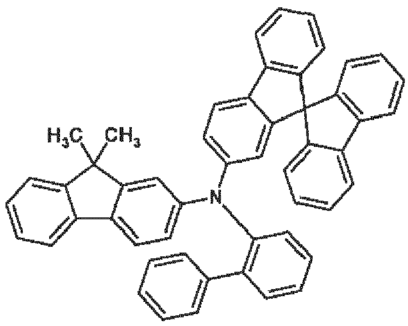

B1.

15. Device comprising at least one organic light emitting diode according to any of the preceding claims, wherein the device is a display device or a lighting device.

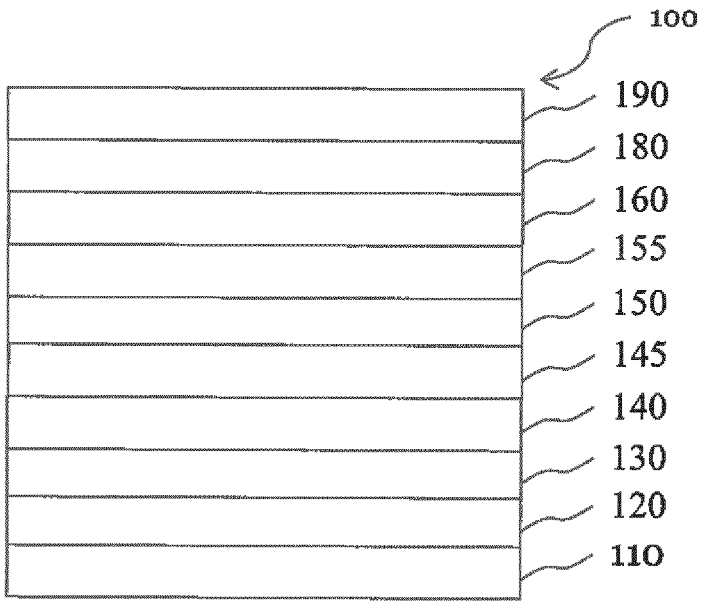


Fig.1

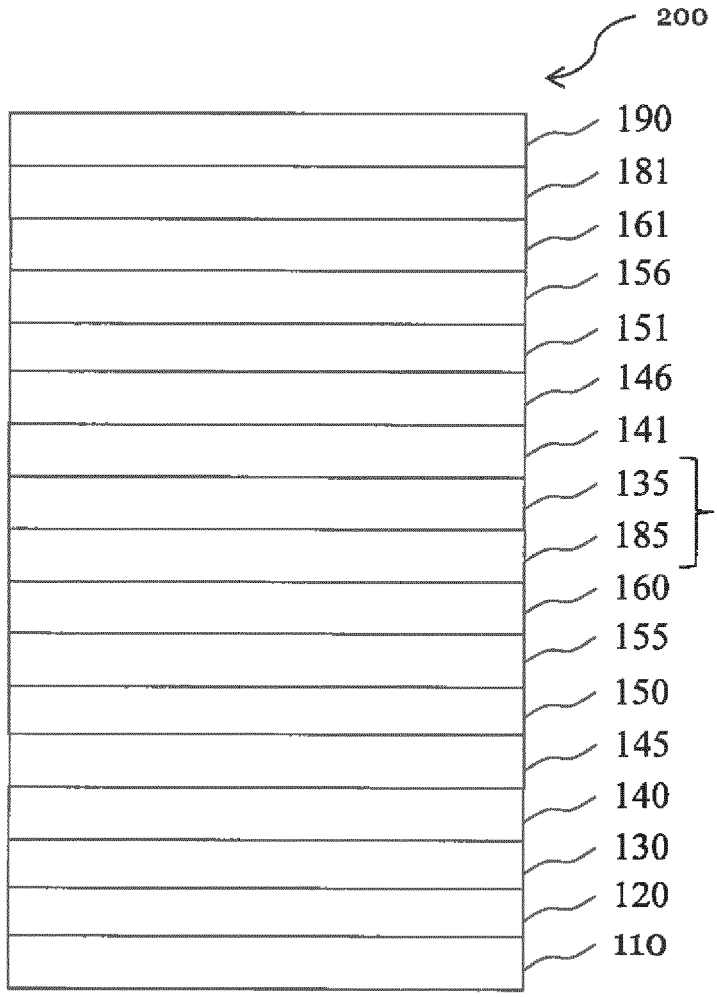
200
190
181
161
156
151
146
141
135
185
160
155
150
145
140
130
120
110

Fig.2

Europäisches Patentamt
European Patent Office
Office européen des brevets

# EUROPEAN SEARCH REPORT

Application Number
EP 19 17 5626

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/058129 A1 (LEE MUN JAE [KR] ET AL) 21 February 2019 (2019-02-21)<br>* paragraphs [0004], [0049], [0075], [0118]; claim 13; examples 1,4,6,10,11; table 5; compounds 1-4,4-4,2-6,3-2,3-6 *<br>----- | 1-8, 10-13,15 | INV. H01L51/54 |
| X | WO 2018/174293 A1 (IDEMITSU KOSAN CO [JP]) 27 September 2018 (2018-09-27)<br>* pages 72,47,73, paragraphs 139,134,77,2,133; example 4; table 1; compounds 9,4, formula [34C], formula [34B], DB-1 *<br>----- | 1-15 | |
| A | CN 109 705 107 A (GUANGZHOU CHINA RAY OPTOELECTRONIC MAT CO LTD) 3 May 2019 (2019-05-03)<br>* paragraphs [0004], [0049], [0075], [0118]; claim 13; examples 1,4,6,10,11; table 5; compounds 1-4,4-4,2-6,3-2,3-6 *<br>----- | 1-15 | |

TECHNICAL FIELDS SEARCHED (IPC)

H01L

The present search report has been drawn up for all claims

1

| Place of search | Date of completion of the search | Examiner |
|---|---|---|
| The Hague | 4 November 2019 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 19 17 5626

This annex lists the patent family members relating to the patent documents cited in the above-mentioned European search report. The members are as contained in the European Patent Office EDP file on The European Patent Office is in no way liable for these particulars which are merely given for the purpose of information.

04-11-2019

| Patent document cited in search report | Publication date | Patent family member(s) | Publication date |
|---|---|---|---|
| US 2019058129 A1 | 21-02-2019 | CN 108138040 A<br>KR 20170037082 A<br>US 2019058129 A1<br>WO 2017052129 A1 | 08-06-2018<br>04-04-2017<br>21-02-2019<br>30-03-2017 |
| WO 2018174293 A1 | 27-09-2018 | NONE | |
| CN 109705107 A | 03-05-2019 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2018138373 A1
- WO 2005086251 A
- EP 1837926 B1
- WO 2007107306 A
- WO 2007107356 A
- WO 2013135237 A1
- WO 2014060526 A1
- WO 2015158886 A1
- WO 2018150006 A1
- WO 2018150048 A1
- WO 2018150049 A1
- WO 2018150050 A1
- WO 2018150051 A1
- US 6140763 A
- US 6614176 B
- US 206248022 B
- EP 2722908 A1
- WO 2016204375 A
- EP 3312899 A
- KR 1020150059142

### Non-patent literature cited in the description

- *CHEMICAL ABSTRACTS,* 1242056-42-3
- *CHEMICAL ABSTRACTS,* 1198399-61-9
- *CHEMICAL ABSTRACTS,* 1824678-59-2
- *CHEMICAL ABSTRACTS,* 1364603-07-5
- *CHEMICAL ABSTRACTS,* 1955543-57-3
- *CHEMICAL ABSTRACTS,* 1835250-94-6